# EUROPEAN PATENT SPECIFICATION

(11) **EP 1 550 217 B1**
(45) Date of publication and mention of the grant of the patent: **25.01.2012**
(21) Application number: 03808181.6
(22) Date of filing: 06.10.2003
(51) Int. Cl.: H03K 19/003

(54) **METHOD AND APPARATUS TO ACTIVELY SINK CURRENT IN AN INTEGRATED CIRCUIT WITH A FLOATING I/O SUPPLY VOLTAGE**
VERFAHREN UND VORRICHTUNG ZUM AKTIVEN ABZIEHEN VON STROM IN EINER INTEGRIERTEN SCHALTUNG MIT EINER SCHWEBENDEN E/A-VERSORGUNGSSPANNUNG
PROCEDE ET APPAREIL D'ECOULEMENT ACTIF DU COURANT DANS UN CIRCUIT INTEGRE PRESENTANT UNE TENSION D'ALIMENTATION D'E-S FLOTTANTE

(30) Priority: 09.10.2002 US 267563
(43) Date of publication of application: 06.07.2005
(73) Proprietor: MediaTek Inc., Hsin-Chu 300 (TW)
(72) Inventor: BOUTAUD, Frederic, Belmont, MA 02478 (US); FITZPATRICK, Sean, M., Westford, MA 01886 (US); KRIVACEK, Paul, D., North Andover, MA 01845 (US)
(74) Representative: Rees, Simon John Lewis
(86) International application number: PCT/US2003/031914
(87) International publication number: WO 2004/034585

(56) References cited:
- EP-A- 0 860 941
- US-B1- 6 317 306
- US-B1- 6 452 235
- PATENT ABSTRACTS OF JAPAN vol. 2003, no. 07, 3 July 2003 (2003-07-03) & JP 2003 078021 A (TOSHIBA CORP), 14 March 2003 (2003-03-14)

## Description

### FIELD OF THE INVENTION

The invention relates to the field of input/output (I/O) circuitry for an integrated circuit (IC), and in particular to I/O circuitry for an IC that provides an adequate current path between an I/O pad and a source of potential, and guarantees a known state on the I/O pad, during times when the I/O voltage is floating.

### BACKGROUND OF THE INVENTION

In a published European patent specification no. EP0860941, there is described an input protection circuit for use in a semiconductor integrated circuit. The circuit comprises a switch device operable to conduct in response to an overvoltage applied between opposite ends thereof. Moreover, the switch device is connected between a wiring conductor connecting an external input terminal to an input node of an input first stage inverter and an output node N3 of a logic gate included within an internal circuit provided in the semiconductor integrated circuit. When an overvoltage is applied to the external input terminal, the switch device conducts so that the electric charge of the overvoltage applied to the external input terminal is discharged through a MOS transistor QP6 or QN7 constituting the logic gate within the internal circuit, to a power supply voltage line or a ground potential line which is laid within the internal circuit for supplying a power supply voltage or a ground potential to the MOS transistor QP6 or QN7. Thus, it is alleged that an effective input protection circuit can be realized whilst occupying a reduced area on the semiconductor chip, with a reduced increase of the input terminal capacitance and with a reduced restriction to the circuit layout.

In a published Japanese patent specification no. JP2003078021, a problem of providing a semiconductor device having an ESD protection circuit is elucidated wherein an element can be made fine and voltage can be lowered. The problem is alleged to be addressed by using an ESD protection circuit with n-type wells formed on a p-type substrate, a p-type well being formed in the n-type wells, and MISFET-MTI and MT2 of n-channels being formed in the p-type well and being disposed between Vdd terminals and an I/O terminal. A parasitic PNP transistor is arranged where p-type emitters are formed in the n-type well at a position near the ends of the p-type well, the n-type well being set to be a base, and the p-type well being the collector and the base being connected to the Vdd terminal. A potential control circuit where the p-type well floats at the time except regular operation is included.

In a published United States patent no. 6, 452, 235, there is described a floating body ESD protection circuit positioned between and coupled to an I/O pad and an internal circuit. A p-type depletion mode transistor is used to control the body of an n-type enhancement mode transistor. When the p-type depletion mode transistor is triggered, the body of n-type enhancement mode transistor remains grounded. If the p-type depletion mode transistor has not been triggered, the body remains in a floating state, lowering the range of the snapback voltage. As a consequence the ESD protection circuit is able to function more rapidly. Similarly, an n-type depletion mode transistor is used to control the body of a p-type enhancement mode transistor. When the n-type depletion mode transistor is triggered, the body remains coupled to a high voltage. If the n-type depletion mode transistor has not been triggered, the body is in a floating state. Thus, the range of the snapback voltage can be lowered, enabling the ESD protection circuit to function more rapidly.

In a published United States patent no. US 6, 317, 306, there is described an electrostatic discharge (ESD) protection circuit. A first NMOS transistor has a source and a gate terminal connected to a ground voltage and a drain terminal connected to the I/O pad. A second NMOS transistor has its source terminal connected to the I/O pad, its drain terminal connected to a voltage source and its gate and substrate terminal connected to the ground voltage. A first PMOS transistor has its drain terminal connected to the ground voltage and a substrate terminal of the first NMOS transistor, its gate terminal connected to the voltage source and its source and substrate terminal connected to the I/O pad. A second PMOS transistor has its source and gate terminal connected to the voltage source, its drain terminal connected to the I/O pad and its substrate terminal connected to a drain terminal of the second NMOS transistor. According to the ESD protection circuit of the invention, whether a positive voltage stress is applied to ground voltage VSS or a negative voltage stress is applied to voltage source VDD, both the parasitic BJT of the first NMOS transistor and the second PMOS transistor can be turned on in advance by triggering the junctions between their substrates and sources, and the capacity of the ESD protection circuit is thus potentially improved.

Many ICs have I/O interface circuitry and pads that are supplied an I/O voltage, V_{I/O}, while the core logic it interfaces to is supplied with a core voltage, V_{core}. When such ICs are used in certain applications, the pad of the IC is required to be capable of sinking a specified amount of current while the I/O supply voltage is floating. Also during these times, it is advantageous to have a known state needed on the pad. Since the pad's driving and protection circuitry are controlled by the I/O voltage, there is no guaranteed that these circuits will provide an adequate current path between the pad and a source of potential (e.g., ground) when the I/O voltage is floating.

Thus, it would be advantageous to have a means of providing an adequate current path and known state for an IC's I/O pad during periods when the I/O voltage is floating.

### SUMMARY OF THE INVENTION

According to a first aspect of the invention an integrated circuit comprising an I/O pad; a combinatorial circuit having a first input coupled to an output signal of the integrated circuit and a second input coupled to an enable signal; at least one I/O transistor having a first terminal coupled to the I/O pad, a second terminal coupled to a source of potential (Vss), and a third terminal coupled to an output of the combinatorial circuit; and wherein a particular state of the output signal and the enable signal causes the combinatorial circuit to output a signal that turns the I/O transistor on, thereby pulling the pad to a known state and providing a current path between the pad and the source of potential (Vss), characterized in that the at least one I/O transistor comprises first and second transistors connected in series, the first and second transistors having a common gate configuration coupled to receive the output of the combinatorial circuit and in that the combinational circuit is designed to turn on the I/O transistor during periods that the I/O voltage is likely to be floating, for example during initialization, reset or recovery from a power-saving mode, in which the I/O voltage is shut off, whereby the I/O pad is pulled to a known state during periods when the I/O voltage is floating.

According to another aspect of the invention a method of pulling an I/O pad of an integrated circuit to a known state and providing a current path between the pad and a source of potential during periods when an I/O voltage is likely to be floating, for example during initialization, reset or recovery from a power-saving mode, in which the I/O voltage is shut off, the method comprising the steps of providing at least one I/O transistor coupled between the I/O pad and a source of potential (Vss); providing a combinational circuit connected to the I/O transistor and an enable signal such that the combinational circuit turns on the transistor in response to the enable signal being in a first state; and switching the enable signal into a first state during periods when an I/O voltage is likely to be floating, thereby pulling the pad to a known state and providing a current path between the pad and the source of potential, characterized in that the at least one transistor comprises first and second transistors connected in series, the first and second transistors having a common gate configuration.

### BRIEF DESCRIPTION OF THE DRAWING

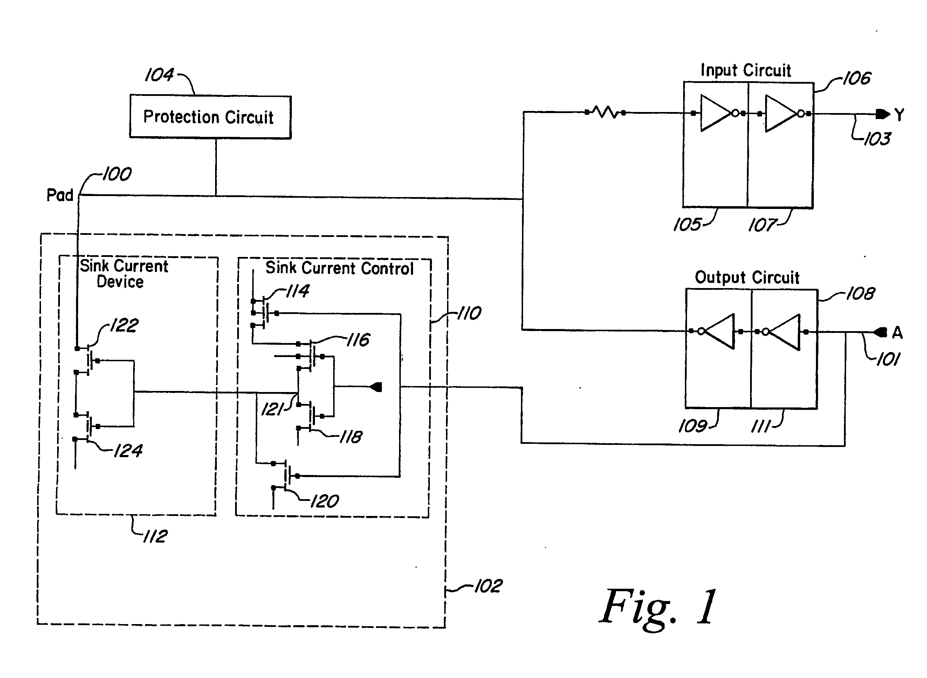

FIG. 1 illustrates an IC pad with supporting circuitry according to the present invention.

### DETAILED DESCRIPTION OF THE INVENTION

Figure 1 (FIG. 1) illustrates an IC pad **100** with supporting circuitry **102** according to the present invention. Supporting circuitry **102** provides an adequate current path and known state for an IC's I/O pad during periods when the I/O voltage is floating. Such periods occur during, for example, initialization, reset, or recovery from a power saving mode in which the I/O voltage is shut off.

Generally, IC pad **100** has output circuitry **108** associated with it to couple output signals from the core logic (not shown) to pad 100. Output signals from the core logic are output on an output line 101. Output circuitry **108** comprises a level shifter, formed from two serially connected inverters **109** and 111, to shift output signals from the core voltage domain to the I/O voltage domain. The I/O voltage is 3.3V, while the core voltage is 1.8V, for example. IC pad may also have input circuitry **106** associated with it for delivering input signals from pad **100** to the core logic via an input line 103. Input circuitry **106** similarly comprises a level shifter, formed from two serially connected inverters **105** and 107, to shift input signals from the I/O voltage domain to the core voltage domain. Protection circuitry **104** may also be associated with pad **100** to protect against electrostatic discharge (ESD), and is powered by the I/O voltage.

As described, IC pad **100** also has supporting circuitry **102** associated with it to provide an adequate current path and known state for pad **100** during periods when the I/O voltage is floating. Circuitry **102** comprises one or more I/O transistors **112** that are controlled by a combinatorial circuit **110**. In the embodiment shown, I/O transistors **112** are pull-down transistors. Combinatorial circuitry **110** is powered by the core voltage and is designed to turn on I/O transistors **112** during periods that the I/O voltage is likely to be floating. Combinatorial circuit **110** can exist in the core area or may be integrated into pad **100**.

Transistors **112** comprise two n channel transistors **122** and **124** serially connected with the drain of transistor **122** connected to the source of transistor **124**. The source of transistor **122** is connected to pad **100**. The drain of transistor **124** is connected to a potential Vₛₛ, which is ground, for example. The gates of transistors **122** and **124** are tied in parallel to the output **121** of combinatorial circuit **110**. Two transistors have been used in the embodiment shown to provide a cascoded configuration, however, one or more serially connected transistors can be used. Turning transistors **112** on provides a current path from pad **100** to ground and pulls pad **100** to a low state (i.e., places pad **100** into a known state).

Combinatorial circuit **110** comprises an inverter formed from p channel transistor **116** and n channel transistor **118** series connected with their sources connected together, forming output node **121**. Their input gates are connected in parallel to an enable signal nOE. The drain electrode of n channel transistor **118** is connected to V_{SS}. The drain of p channel transistor **116** is connected to the source of a p channel disable transistor **114**. The drain of disable transistor **114** is connected to a potential, V_{DD} (i.e., the core voltage, V_{core}). In addition, a p channel pull-down transistor **120** has its source connected to output node **121**, and its drain connected to the potential V_{SS}. The gates of the disable transistor **114** and pull-down transistor **120** are tied in parallel to the output signal A from the core logic.

A particular state of the output signal A and the enable signal nOE causes the combinatorial circuit **110** to output a signal that turns transistors **112** on, thereby pulling pad **100** to a known state and providing a current path between the pad and the source of potential. During periods when the I/O voltage is likely to be floating, such as on reset or initialization, the output A of the core logic will be driven low. The low state on the output A causes p channel transistor **114** to turn on, connected the drain of p channel transistor **116** to V_{DD}. The low state on output A also causes n channel transistor **120** to turn off, disconnecting output node **121** from V_{SS}. At the same time, nOE is driven low. This causes output node **121** to go high, turning on transistors **112** so as to provide an adequate current path and known state for pad **100**.

At times when the output signal A is not low (i.e., it is high), transistor **114** turns off, disconnecting the drain of transistor **116** from V_{DD}, thereby disabling the inverter formed by transistors **116** and **118**. Transistor **120** is turned on at this time, pulling output **121** low, thereby causing transistors **112** to be in the off state. Also, during times when the I/O voltage is not likely to be floating, nOE is driven high. This causes output **121** to go low, thereby causing transistors **112** to be in the off state. Thus, even when output A is low during periods when the I/O voltage is not floating, transistors **112** are disabled.

Although the present invention has been shown and described with respect to several preferred embodiments thereof, various changes, omissions and additions to the form and detail thereof, may be made therein, without departing from the scope of the invention. For example, while the present invention has been described primarily in relation to an IC having I/O pads that interface to an off-chip system, the present invention is not limited thereto. Instead, the I/O circuitry according to the present invention could be interfacing between several subsystems integrated onto a single IC, rather than interfacing between the off-chip world and the on-chip logic. Thus, the term I/O pad should be understood to generally encompass the interface point of the I/O circuitry, even if a "pad" is not specifically there.

## Claims

1. An integrated circuit comprising:
an I/O pad (100);
a combinatorial circuit (110) having a first input coupled to an output signal of the integrated circuit and a second input coupled to an enable signal;
at least one I/O transistor (112) having a first terminal coupled to the I/O pad (100), a second terminal coupled to a source of potential (Vss), and a third terminal coupled to an output of the combinatorial circuit (110); and wherein a particular state of the output signal and the enable signal causes the combinatorial circuit (110) to output a signal that turns the I/O transistor (112) on, thereby pulling the pad (100) to a known state and providing a current path between the pad (100) and the source of potential (Vss),
**characterized in that**
the at least one I/O transistor (112) comprises first and second transistors (122, 124) connected in series, the first and second transistors (122, 124) having a common gate configuration coupled to receive the output of the combinatorial circuit (110), and **in that** the combinational circuit (110) is designed to turn on the I/O transistor (112) during periods that the I/O voltage is likely to be floating, for example during initialization, reset or recovery from a power-saving mode, in which the I/O voltage is shut off, whereby the I/O pad (100) is pulled to a known state during periods when the I/O voltage is floating.

2. An integrated circuit as claimed in claim 1, wherein the combinatorial circuit (110) comprises:
an inverter with an input and an output, the inverter output connected to the output of the combinatorial circuit and the inverter input connected to the second input, wherein the enable signal in a first state results in an inverter output that causes the I/O transistor to turn on;
a disable transistor connected to the inverter and first input such that when the output signal is in a first state the inverter is enabled and when the output signal is in a second state the inverter is disabled; and
a transistor connected to the inverter output and first input such that when the output signal is in a first state the transistor is turned off and when the output signal is in a second state the transistor is turned on, forcing the inverter output to a known state, wherein the known state causes the I/O transistor to turn off.

3. An integrated circuit as claimed in claim 1, wherein the source of potential is ground.

4. A method of pulling an I/O pad (100) of an integrated circuit to a known state and providing a current path between the pad (100) and a source of potential during periods when an I/O voltage is likely to be floating, for example during initialization, reset or recovery from a power-saving mode, in which the I/O voltage is shut off, the method comprising the steps of:
(a) providing at least one I/O transistor (112) coupled between the I/O pad (100) and a source of potential (Vss);
(b) providing a combinational circuit connected to the I/O transistor and an enable signal such that the combinational circuit turns on the transistor in response to the enable signal being in a first state; and
(c) switching the enable signal into a first state during periods when an I/O voltage is likely to be floating, thereby pulling the pad to a known state and providing a current path between the pad and the source of potential, **characterized in that** the at least one transistor (112) comprises first and second transistors (122, 124) connected in series, the first and second transistors (122, 124) having a common gate configuration.

5. A method as claimed in claim 4, wherein the combinatorial circuit comprises:
an inverter with an input and an output, the inverter output connected to the I/O transistor's gate and the inverter input connected to an enable signal, wherein the enable signal in a first state results in an inverter output that causes the I/O transistor to turn on;
a disable transistor connected to the inverter and an output signal of the integrated circuit such that when the output signal is in a first state the inverter is enabled and when the output signal is in a second state the inverter is disabled; and
a transistor connected to the inverter output and the output signal of the integrated circuit such that when the output signal is in a first state the transistor is turned off and when the output signal is in a second state the transistor is turned on, forcing the inverter output to a known state, wherein the known state causes the I/O transistor to turn off.

## Patentansprüche

1. Integrierte Schaltung, umfassend:
einen I/O-Anschlussfleck (100);
eine Verknüpfungsschaltung (110), wobei ein erster Eingang der Verknüpfungsschaltung mit einem Ausgabesignal der integrierten Schaltung verbunden ist und ein zweiter Eingang mit einem Freigabesignal verbunden ist;
mindestens einen I/O-Transistor (112), wobei ein erster Anschluss des I/O-Transistors mit dem I/O-Anschlussfleck (100) gekoppelt ist, ein zweiter Anschluss mit einer Quelle für ein Potential (Vss) verbunden ist, und ein dritter Anschluss mit einem Ausgang der Verknüpfungsschaltung (110) verbunden ist, und ein bestimmter Status des Ausgabesignals und des Freigabesignals die Verknüpfungsschaltung (110) veranlasst, ein Signal auszugeben, das den I/O-Transistor (112) durchschaltet, wodurch der Anschlussfleck (100) auf einen bekannten Status gezogen wird und ein Strompfad zwischen dem Anschlussfleck (100) und der Quelle für das Potential (Vss) hergestellt wird,
**dadurch gekennzeichnet, dass** der mindestens eine I/O-Transistor (112) in Reihe geschaltete erste und zweite Transistoren (122, 124) umfasst, wobei die ersten und zweiten Transistoren (122, 124) eine gemeinsame Gatekonfiguration aufweisen, die so geschaltet ist, dass sie das Ausgabesignal der Verknüpfungsschaltung (110) empfängt, und dadurch, dass die Verknüpfungsschaltung (110) dafür entworfen ist, den I/O-Transistor (112) während der Perioden einzuschalten, in denen es wahrscheinlich ist, dass die I/O-Spannung schwebt, beispielsweise während des Initialisierens, des Zurücksetzens oder der Rückkehr aus einem Energiesparmodus, in dem die I/O-Spannung abgeschaltet ist, wodurch der I/O-Anschlussfleck (100) während der Perioden, in denen die I/O-Spannung schwebt, auf einen bekannten Status gezogen wird.

2. Integrierte Schaltung nach Anspruch 1, wobei die Verknüpfungsschaltung (110) umfasst:
einen Inverter mit einem Eingang und einem Ausgang, wobei der Inverterausgang mit dem Ausgang der Verknüpfungsschaltung verbunden ist und der Invertereingang an den zweiten Eingang angeschlossen ist, und das Freigabesignal in einem ersten Status zu einem Inverterausgabesignal führt, das den I/O-Transistor veranlasst, durchzuschalten;
einen Sperrtransistor, der so an den Inverter und den ersten Eingang angeschlossen ist, dass der Inverter freigegeben ist, wenn sich das Ausgabesignal in einem ersten Status befindet, und der Inverter gesperrt ist, wenn sich das Ausgabesignal in einem zweiten Status befindet; und
einen Transistor, der so mit dem Inverterausgang und dem ersten Eingang verbunden ist, dass der Transistor sperrt, wenn sich das Ausgabesignal in einem ersten Status befindet, und dass der Transistor durchschaltet, wenn sich das Ausgabesignal in einem zweiten Status befindet, wodurch der Inverterausgang in einen bekannten Status gezwungen wird, und der bekannte Status den I/O-Transistor veranlasst, zu sperren.

3. Integrierte Schaltung nach Anspruch 1, wobei die Quelle für das Potential Masse ist.

4. Verfahren zum Ziehen eines I/O-Anschlussflecks (100) einer integrierten Schaltung auf einen bekannten Status und zum Herstellen eines Strompfads zwischen dem Anschlussfleck (100) und einer Potentialquelle während der Perioden, in denen es wahrscheinlich ist, dass eine I/O-Spannung schwebt, beispielsweise während des Initialisierens, des Zurücksetzens oder der Rückkehr aus einem Energiesparmodus, in dem die I/O-Spannung abgeschaltet ist, wobei das Verfahren die Schritte umfasst:
a) das Bereitstellen mindestens eines I/O-Transistors (112), der zwischen den I/O-Anschlussfleck (100) und eine Quelle für ein Potential (Vss) geschaltet ist;
b) das Bereitstellen einer Verknüpfungsschaltung, die an den I/O-Transistor angeschlossen ist, und eines Freigabesignals derart, dass die Verknüpfungsschaltung den Transistor dann durchschaltet, wenn sich das Freigabesignal in einem ersten Status befindet; und
c) das Schalten des Freigabesignals in einen ersten Status während der Perioden, in denen es wahrscheinlich ist, dass eine I/O-Spannung schwebt, wodurch der Anschlussfleck auf einen bekannten Status gezogen wird, und das Bereitstellen eines Strompfads zwischen dem Anschlussfleck und der Potentialquelle, **dadurch gekennzeichnet, dass** der mindestens eine Transistor (112) in Reihe geschaltete erste und zweite Transistoren (122, 124) umfasst, wobei die ersten und zweiten Transistoren (122, 124) eine gemeinsame Gatekonfiguration aufweisen.

5. Verfahren nach Anspruch 4, wobei die Verknüpfungsschaltung umfasst:
einen Inverter mit einem Eingang und einem Ausgang, wobei der Inverterausgang mit dem Gate des I/O-Transistors verbunden ist und der Invertereingang an ein Freigabesignal angeschlossen ist, und das Freigabesignal in einem ersten Status zu einem Inverterausgabesignal führt, das bewirkt, dass der I/O-Transistor durchschaltet;
einen Sperrtransistor, der so an den Inverter und ein Ausgabesignal der integrierten Schaltung angeschlossen ist, dass der Inverter freigegeben ist, wenn sich das Ausgabesignal in einem ersten Status befindet, und der Inverter gesperrt ist, wenn sich das Ausgabesignal in einem zweiten Status befindet; und
einen Transistor, der so mit dem Inverterausgang und dem Ausgabesignal der integrierten Schaltung verbunden ist, dass der Transistor sperrt, wenn sich das Ausgabesignal in einem ersten Status befindet, und dass der Transistor durchschaltet, wenn sich das Ausgabesignal in einem zweiten Status befindet, wodurch der Inverterausgang in einen bekannten Status gezwungen wird, und der bekannte Status den I/O-Transistor veranlasst, zu sperren.

## Revendications

1. Circuit intégré, comprenant :
une zone d'entrée/sortie (100) ;
un circuit combinatoire (110) comportant une première entrée couplée à un signal de sortie du circuit intégré et une deuxième entrée couplée à un signal de validation ;
au moins un transistor d'entrée/sortie (112) comportant une première borne couplée à la zone d'entrée/sortie (100), une deuxième borne couplée à une source de potentiel (Vss), et une troisième borne couplée à une sortie du circuit combinatoire (110) ; et dans lequel un état particulier du signal de sortie et du signal de validation provoque la délivrance en sortie par le circuit combinatoire (110) d'un signal qui rend passant le transistor d'entrée/sortie (112), de façon à mettre la zone (100) à un état connu et à constituer un trajet de courant entre la zone (100) et la source de potentiel (Vss),
**caractérisé en ce que** :
le au moins un transistor d'entrée/sortie (112) comprend des premier et deuxième transistors (122, 124) connectés en série, les premier et deuxième transistors (122, 124) ayant une configuration à grilles communes couplée de façon à recevoir la sortie du circuit combinatoire (110), et **en ce que** le circuit combinatoire (110) est conçu de façon à rendre passant le transistor d'entrée/sortie (112) durant des périodes pendant lesquelles la tension d'entrée/sortie est susceptible d'être flottante, par exemple durant une initialisation, une remise à zéro ou un rétablissement à partir d'un mode d'économie d'énergie, pendant lesquels la tension d'entrée/sortie est interrompue, grâce à quoi la zone d'entrée/sortie (100) est mise à un état connu durant des périodes pendant lesquelles la tension d'entrée/sortie est flottante.

2. Circuit intégré selon la revendication 1, dans lequel le circuit combinatoire (110) comprend :
un inverseur avec une entrée et une sortie, la sortie de l'inverseur étant connectée à la sortie du circuit combinatoire et l'entrée de l'inverseur étant connectée à la deuxième entrée, le signal de validation, dans un premier état, produisant en résultat une sortie de l'inverseur qui rend passant le transistor d'entrée/sortie ;
un transistor d'invalidation connecté à l'inverseur et à la première entrée, de telle sorte que, lorsque le signal de sortie est dans un premier état, l'inverseur soit validé, et que, lorsque le signal de sortie est dans un deuxième état, l'inverseur soit invalidé ; et
un transistor connecté à la sortie de l'inverseur et à la première entrée, de telle sorte que, lorsque le signal de sortie est dans un premier état, le transistor soit bloqué, et que, lorsque le signal de sortie est dans un deuxième état, le transistor soit rendu passant, forçant la sortie de l'inverseur à un état connu, l'état connu rendant le transistor d'entrée/sortie bloqué.

3. Circuit intégré selon la revendication 1, dans lequel la source de potentiel est la masse.

4. Procédé pour mettre une zone d'entrée/sortie (100) d'un circuit intégré à un état connu et pour constituer un trajet de courant entre la zone (100) et une source de potentiel durant des périodes pendant lesquelles une tension d'entrée/sortie est susceptible d'être flottante, par exemple durant l'initialisation, la remise à zéro ou le rétablissement à partir d'un mode d'économie d'énergie, pendant lesquels la tension d'entrée/sortie est interrompue, le procédé comprenant les étapes consistant à :
(a) disposer au moins un transistor d'entrée/sortie (112) couplé entre la zone d'entrée/sortie (100) et une source de potentiel (Vss) ;
(b) disposer un circuit combinatoire connecté au transistor d'entrée/sortie et à un signal de validation, de telle sorte que le circuit combinatoire rende passant le transistor en réponse au fait que le signal de validation est dans un premier état ; et
(c) commuter le signal de validation à un premier état durant des périodes pendant lesquelles une tension d'entrée/sortie est susceptible d'être flottante, de façon à mettre ainsi la zone à un état connu et à constituer ainsi un trajet de courant entre la zone et la source de potentiel,
**caractérisé en ce que** le au moins un transistor (112) comprend des premier et deuxième transistors (122, 124) connectés en série, les premier et deuxième transistors (122, 124) ayant une configuration à grilles communes.

5. Procédé selon la revendication 4, dans lequel le circuit combinatoire comprend :
un inverseur avec une entrée et une sortie, la sortie de l'inverseur étant connectée à la grille du transistor d'entrée/sortie et l'entrée de l'inverseur étant connectée à un signal de validation, le signal de validation, dans un premier état, produisant en résultat une sortie de l'inverseur qui rend le transistor d'entrée/sortie passant ;
un transistor d'invalidation connecté à l'inverseur et à un signal de sortie du circuit intégré, de telle sorte que, lorsque le signal de sortie est dans un premier état, l'inverseur soit validé, et que, lorsque le signal de sortie est dans un deuxième état, l'inverseur soit invalidé ; et
un transistor connecté à la sortie de l'inverseur et au signal de sortie du circuit intégré, de telle sorte que, lorsque le signal de sortie est dans un premier état, le transistor soit bloqué, et que, lorsque le signal de sortie est dans un deuxième état, le transistor soit rendu passant, forçant la sortie de l'inverseur dans un état connu, l'état connu rendant le transistor d'entrée/sortie bloqué.
